# EUROPEAN PATENT SPECIFICATION

(11) **EP 4 382 935 B1**
(45) Date of publication and mention of the grant of the patent: **28.01.2026**
(21) Application number: 23753094.4
(22) Date of filing: 06.02.2023
(51) Int. Cl.: G01R 31/3842, G01R 19/165, G01R 19/10, G01R 19/00, G01R 31/396, H01M 10/48, H01M 10/44, H01M 10/42

(54) **BATTERY MANAGEMENT APPARATUS AND METHOD**
BATTERIEVERWALTUNGSVORRICHTUNG UND -VERFAHREN
DISPOSITIF ET PROCÉDÉ DE GESTION DE BATTERIE

(30) Priority: 08.02.2022 KR 20220016361
(43) Date of publication of application: 12.06.2024
(73) Proprietor: LG Energy Solution, Ltd., Seoul 07335 (KR)
(72) Inventor: LEE, Sun-Jong, Daejeon 34122 (KR); KIM, Cheol-Taek, Daejeon 34122 (KR); KIM, Ji-Su, Daejeon 34122 (KR); PARK, Hee-Ju, Daejeon 34122 (KR)
(74) Representative: Plasseraud IP
(86) International application number: PCT/KR2023/001679
(87) International publication number: WO 2023/153744

(56) References cited:
- WO-A1-2022/001977
- CN-A- 113 875 118
- JP-B1- 6 968 302
- KR-A- 20210 040 423
- KR-B1- 101 548 327
- KR-B1- 101 548 327
- US-A1- 2012 158 330
- US-A1- 2019 229 378
- US-A1- 2020 243 920
- DOTOLI MATTEO ET AL: "Detection of Lithium Plating in Li-Ion Cell Anodes Using Realistic Automotive Fast-Charge Profiles", BATTERIES, vol. 7, no. 3, 7 July 2021 (2021-07-07), Basel, pages 46, XP093223661, ISSN: 2313-0105, DOI: 10.3390/batteries7030046

## Description

### TECHNICAL FIELD

The present application claims priority to Korean Patent Application No. 10-2022-0016361 filed on February 8, 2022 in the Republic of Korea.

The present disclosure relates to a battery management apparatus and method, and more particularly, to a battery management apparatus and method capable of diagnosing whether or not lithium precipitation of a battery occurs.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

A lot of research is being conducted on these batteries in terms of high-capacity and high-density, but the aspect of improving lifespan and safety is also important. To this end, it is necessary to suppress the decomposition reaction with the electrolyte on the surface of the electrode, and it is required to prevent overcharging and overdischarging.

In particular, it is necessary to prevent the phenomenon that lithium precipitation occurs on the surface of the negative electrode (lithium plating, Li-plating). When lithium precipitation occurs on the surface of the negative electrode, it causes side reactions with the electrolyte and changes in the kinetic balance of the battery, which causes battery degradation. In addition, since an internal short circuit of the battery may occur as lithium metal precipitation occurs on the surface of the negative electrode, there is a risk of ignition and explosion due to the internal short circuit.

Conventionally, lithium precipitation was diagnosed based on the voltage change over time in the idle section after charging. However, this method is applicable when a large amount of lithium precipitation occurs in the corresponding idle period, and there is a problem in that it is not possible to accurately diagnose whether or not lithium precipitation occurs when lithium precipitation accumulates little by little.

Therefore, it is necessary to develop a technology capable of accurately diagnosing lithium precipitation even when lithium precipitation gradually accumulates.

US2012/158330, KR101548327 B1, WO2022/001977 A1 and US2020/243920 A1 each relate to diagnosing the state of batteries. Document Dotoli Matteo et al: "Detection of Lithium plating in Li-ion cell anodes using realistic automotive fast-charge profiles", BATTERIES, vol. 7, No. 3, 7 July 2021, page 46, Basel, ISSN 2313-0105, DOI: 10.3390/batteries7030046, relates to detecting lithium precipitation in batteries.

### DISCLOSURE

### Technical Problem

The present disclosure is designed to solve the problems of the related art, and therefore the present disclosure is directed to providing a battery management apparatus and method for diagnosing whether or not lithium precipitation occurs in a battery based on a voltage at which an inflection point is generated in a battery profile indicating a voltage change over time.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure is as provided in claim 1.

The control unit may be configured to diagnose whether or not lithium precipitation occurs based on a voltage deviation between the reference voltage and the target voltage.

The control unit may be configured to diagnose that the lithium precipitation occurs in the battery, when the voltage deviation is equal to or greater than a preset threshold voltage.

The control unit may be configured to diagnose that the lithium precipitation does not occur in the battery, when the voltage deviation is less than the threshold voltage.

The control unit may be configured to determine a reference temperature corresponding to the target temperature, determine a reference current amount corresponding to the target current amount, and determine the reference voltage corresponding to the reference temperature and the reference current amount in the voltage table.

The control unit may be configured to determine a temperature closest to the target temperature among a plurality of predetermined temperatures as the reference temperature, and determine a current closest to the target current amount among a plurality of predetermined current amounts as the reference current amount.

The control unit may be configured to determine at least one reference temperature belonging to a predetermined temperature range from the target temperature among a plurality of predetermined temperatures, determine at least one reference current amount belonging to a predetermined current amount range from the target current amount among a plurality of predetermined current amounts, and determine a minimum voltage among the at least one voltage according to the combination of the determined at least one reference temperature and the determined at least one reference current amount as the reference voltage.

The control unit may be configured to determine the reference voltage corresponding to the target temperature and the target current amount in the voltage table by using an interpolation method, when a plurality of predetermined temperatures do not have the same value as the target temperature or a plurality of predetermined current amounts do not have the same value as the target current amount.

The voltage table may be a table in which a voltage of the battery according to a temperature of the battery and a current amount of the battery is recorded.

The battery profile may be a profile recorded to represent the voltage according to a charging time or a discharging time when the battery is charged or discharged with a constant current.

A battery management apparatus according to another aspect of the present disclosure may further comprise a storage unit configured to store the voltage table.

The control unit may be configured to store the reference voltage corresponding to the target temperature and the target current amount in advance in the voltage table stored in the storage unit, and update the reference voltage to the target voltage when the target voltage is less than the reference voltage.

A battery pack according to another aspect of the present disclosure may comprise the battery management apparatus according to an aspect of the present disclosure.

A battery management server according to still another aspect of the present disclosure may comprise the battery management apparatus according to an aspect of the present disclosure.

A battery management method according to still another aspect of the present disclosure is as provided according to claim 13.

### Advantageous Effects

According to one aspect of the present disclosure, whether or not lithium precipitation occurs in a battery can be accurately diagnosed. In particular, even when precipitation of lithium metal progresses slowly, it is possible to diagnose whether or not precipitation of lithium metal occurs.

In addition, according to one aspect of the present disclosure, it is possible to rapidly diagnose whether or not lithium precipitation occurs based on measurement data in the charging and discharging process of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram schematically showing a battery profile according to an embodiment of the present disclosure.
FIG. 3 is a diagram schematically showing a voltage behavior of a reference battery and a first battery according to an embodiment of the present disclosure.
FIG. 4 is a diagram schematically showing a voltage behavior of a reference battery and a second battery according to an embodiment of the present disclosure.
FIG. 5 is a diagram schematically showing a voltage table according to an embodiment of the present disclosure.
FIG. 6 is a diagram schematically showing a positive electrode potential curve and a negative electrode potential curve of a normal battery.
FIG. 7 is a diagram schematically showing a positive electrode potential curve and a negative electrode potential curve of a lithium precipitation battery.
FIG. 8 is a diagram schematically showing an exemplary configuration of a battery pack according to another embodiment of the present disclosure.
FIG. 9 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

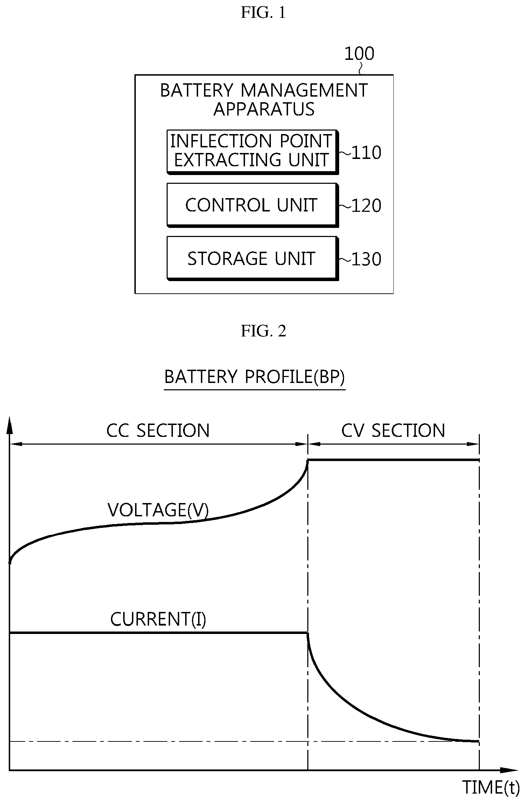

FIG. 1 is a diagram schematically showing a battery management apparatus 100 according to an embodiment of the present disclosure.

Specifically, the battery management apparatus 100 diagnoses whether lithium metal precipitation occurs in the battery. Here, the battery means one physically separable independent cell including a negative electrode terminal and a positive electrode terminal. For example, one lithium-ion battery or lithium polymer battery may be regarded as a battery.

Referring to FIG. 1, the battery management apparatus 100 includes an inflection point extracting unit 110 and a control unit 120.

The inflection point extracting unit 110 is configured to extract an inflection point from a battery profile BP representing a voltage change of the battery over time.

Here, the battery profile BP is generated during charging or discharging of the battery, and is a profile representing a voltage change of the battery over time. The battery profile BP is a profile recorded to represent a voltage according to a charging time or discharging time when the battery is charged or discharged with a constant current.

FIG. 2 is a diagram schematically showing a battery profile BP according to an embodiment of the present disclosure. Specifically, FIG. 2 is a diagram showing a battery profile BP generated during a battery charging process.

In the embodiment of FIG. 2, the charging section of the battery may be divided into a CC section charged with a constant current and a CV section charged with a constant voltage. Preferably, since the CV section is a section in which voltage change is not significant, an inflection point may not appear. Therefore, the inflection point extracting unit 110 may extract an inflection point from the CC section of the battery profile BP.

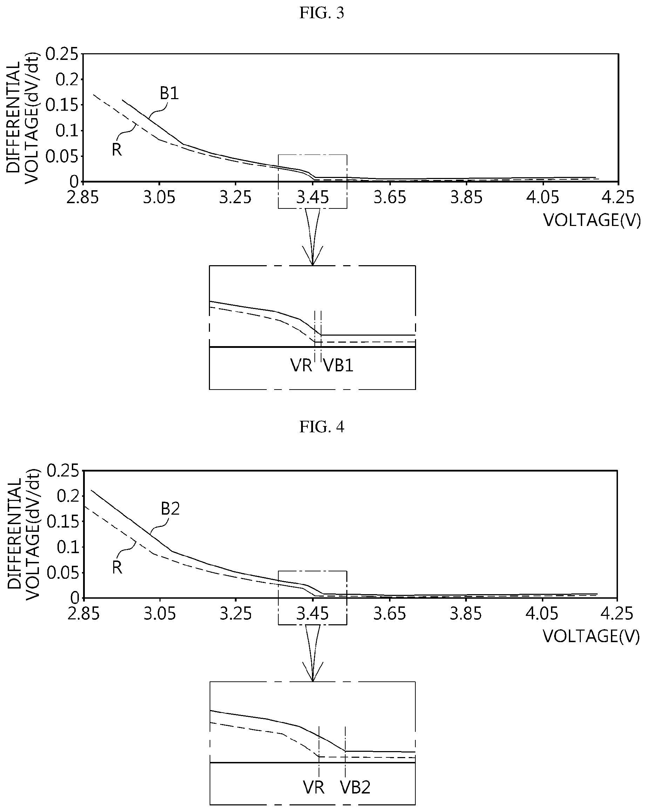

The voltage corresponding to the inflection point of a lithium precipitation battery may be higher than the voltage corresponding to the inflection point of a normal battery. The inflection points of a normal battery and a lithium precipitation battery will be described in detail with reference to FIGS. 3 and 4 below.

FIG. 3 is a diagram schematically showing a voltage behavior of a reference battery R and a first battery B1 according to an embodiment of the present disclosure. FIG. 4 is a diagram schematically showing a voltage behavior of a reference battery R and a second battery B2 according to an embodiment of the present disclosure.

Specifically, FIGS. 3 and 4 are diagrams showing a corresponding relationship between a voltage and a differential voltage (dV/dt) in the CC section. Here, the differential voltage means an instantaneous rate of change of voltage over time.

In the embodiments of FIGS. 3 and 4, the reference battery R is a battery in a BOL (Beginning of Life) state and is a normal battery in which lithium metal is not precipitated. The first battery B1 is a battery in a MOL (Middle of Life) state, and is a normal battery in which lithium metal is not precipitated. The second battery B2 is a battery in a MOL state and a lithium precipitation battery in which lithium metal is precipitated.

Referring to FIGS. 3 and 4, the inflection point of the reference battery R may appear at a reference voltage VR. The inflection point of the first battery B1 may appear at a first voltage VB1, and the inflection point of the second battery B2 may appear at a second voltage VB2. That is, the voltage corresponding to the inflection point of the lithium precipitation battery may be greater than the voltage corresponding to the inflection point of the normal battery. Therefore, considering the reference voltage VR as a criterion, the voltage corresponding to the inflection point of the lithium precipitation battery may be shifted to a high potential side more than the voltage corresponding to the inflection point of the normal battery.

Therefore, the inflection point extracting unit 110 may extract an inflection point from the battery profile BP so that the control unit 120 may diagnose lithium precipitation of the battery based on the voltage corresponding to the inflection point.

The control unit 120 is configured to determine a target voltage, a target temperature, and a target current amount of the battery corresponding to the inflection point.

Specifically, in the process of charging or discharging the battery, not only the voltage of the battery but also the temperature and the charging and discharging current amount of the battery may be measured. In one embodiment, the voltage, temperature and current amount may be measured at the same or different periods. Preferably, the voltage, temperature and current amount may be measured at the same period. Here, the current amount means an accumulated charge amount or an accumulated discharge amount, and may be calculated through current integration.

For example, in the embodiment of FIG. 3, the control unit 120 may determine the first voltage VB1 where the inflection point of the first battery B1 appears as the target voltage. Also, the first temperature corresponding to the target voltage may be determined as the target temperature. In addition, the first current amount corresponding to the target voltage may be determined as the target current amount. Here, it should be noted that the first temperature and the first current amount corresponding to the target voltage are a temperature and a current amount at the time when the inflection point appears among temperatures and current amounts of the first battery B1 measured during the charging process.

The control unit 120 may be configured to determine a reference voltage corresponding to the target temperature and the target current amount in a preset voltage table.

Here, the voltage table may be a table in which the voltage of the battery according to the temperature of the battery and the current amount of the battery are recorded. Specifically, the voltage table is generated through experiments using the reference battery R in a BOL state, and may be a table in which battery voltages for battery temperatures and current amounts are recorded.

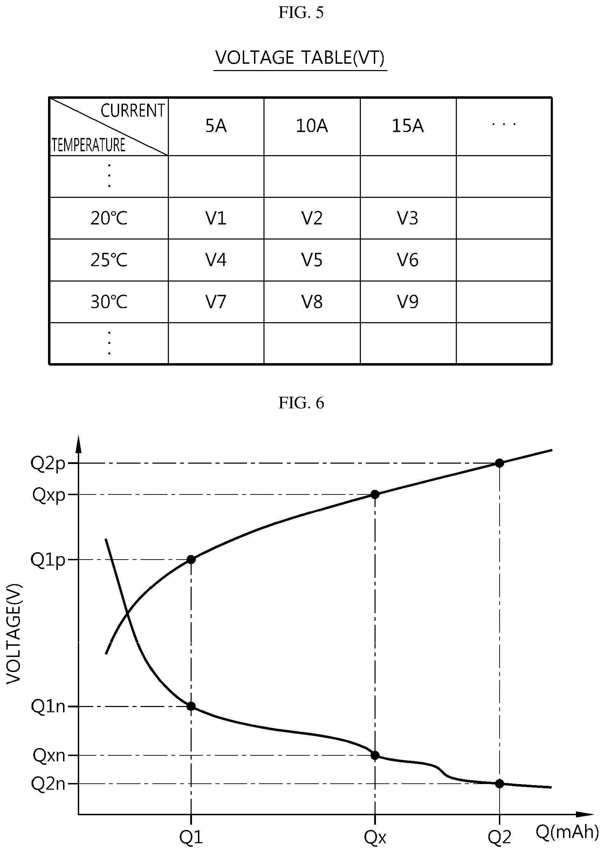

FIG. 5 is a diagram schematically showing a voltage table VT according to an embodiment of the present disclosure.

Referring to FIG. 5, in the voltage table VT, voltages measured at temperature intervals of 5°C and current amount intervals of 5A may be recorded. For example, in the case where the temperature is 20°C, when the current amount is 5A, 10A, and 15A, the voltage is V1, V2, and V3, respectively. In the case where the temperature is 25°C, when the current amount is 5A, 10A, and 15A, the voltage is V4, V5, and V6, respectively. In the case where the temperature is 30°C, when the current amount is 5A, 10A, and 15A, the voltage is V7, V8, and V9, respectively.

In FIG. 5, which is a non-limiting embodiment, for convenience of explanation, corresponding voltages (V1 to V9) are shown only for a predetermined temperature range (20°C to 30°C) and a predetermined current amount range (5A to 15A). However, it should be noted that the temperature interval and the current amount interval of the voltage table VT are not limited by the embodiment of FIG. 5.

For example, in the embodiment of FIG. 3, it is assumed that the target temperature corresponding to the first voltage VB1 is 25°C, and the corresponding target current amount is 10A. The control unit 120 may determine a reference voltage corresponding to the target temperature and the target current amount in the voltage table VT as V5.

The control unit 120 may be configured to diagnose whether or not lithium precipitation occurs in the battery based on the reference voltage and the target voltage.

Specifically, the control unit 120 may be configured to diagnose whether or not lithium precipitation occurs based on a voltage deviation between the reference voltage and the target voltage.

As described above, referring to FIGS. 3 and 4, the voltage corresponding to the inflection point of the lithium precipitation battery may be further shifted to the high potential side compared to the voltage corresponding to the inflection point of the normal battery. Therefore, the control unit 120 may diagnose whether or not lithium precipitation occurs in the battery based on the voltage deviation between the reference voltage and the target voltage.

For example, if the voltage deviation is greater than or equal to a preset threshold voltage, the control unit 120 may be configured to diagnose that lithium is precipitated in the battery. Conversely, if the voltage deviation is less than the threshold voltage, the control unit 120 may be configured to diagnose that lithium is not precipitated in the battery. For example, the threshold voltage may be set to 10mV.

In the embodiments of FIGS. 3 and 4, it is assumed that temperatures and the current amounts corresponding to the inflection points of the reference battery R, the first battery B1 and the second battery B2 are the same. That is, it is assumed that reference voltage VR for the reference battery R is the reference voltage for the first battery B1 and the second battery B2. Since the first battery B1 is a normal battery, a voltage deviation between the reference voltage VR and the first voltage VB1 may be less than the threshold voltage. Since the second battery B2 is a lithium precipitation battery, the voltage deviation between the reference voltage VR and the second voltage VB2 may be greater than or equal to the threshold voltage. Accordingly, the control unit 120 may diagnose the first battery B1 as a normal battery and diagnose the second battery B2 as a lithium precipitation battery.

That is, the battery management apparatus 100 according to an embodiment of the present disclosure has an advantage of quickly diagnosing whether or not lithium precipitation occurs based on the battery profile BP (constant current charging and discharging profile).

In addition, since the battery management apparatus 100 determines the reference voltage by considering the temperature and the current amount of the battery, the accuracy of the diagnosis result may be improved through comparison between the reference voltage and the target voltage.

Meanwhile, the control unit 120 provided in the battery management apparatus 100 may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

Meanwhile, the inflection point extracting unit 110 may extract a plurality of inflection points from the battery profile BP. Specifically, the inflection point extracting unit 110 may extract two or more inflection points from the CC section of the battery profile BP.

In this case, the control unit 120 may determine a target voltage and a reference voltage for each of the plurality of inflection points, and calculate a voltage deviation between the corresponding target voltage and the reference voltage.

Lithium precipitation not only affects the performance of the battery, but may also cause fatal accidents such as fire and explosion. Accordingly, the control unit 120 may diagnose that lithium metal is precipitated in the battery if at least one of the plurality of calculated voltage deviations is equal to or greater than the threshold voltage.

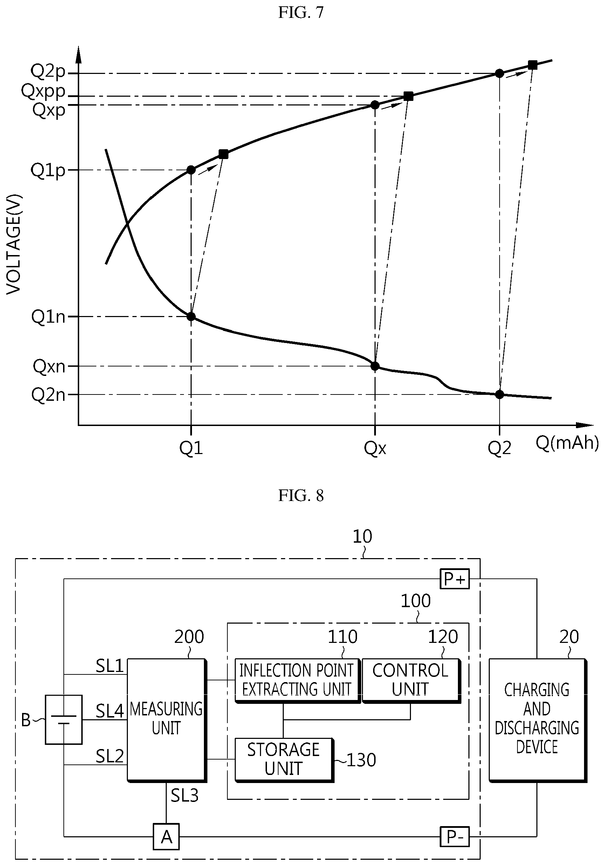

Hereinafter, the cause of the increase in the target voltage corresponding to the inflection point when lithium is precipitated will be described through FIGS. 6 and 7.

FIG. 6 is a diagram schematically showing a positive electrode potential curve and a negative electrode potential curve of a normal battery. FIG. 7 is a diagram schematically showing a positive electrode potential curve and a negative electrode potential curve of a lithium precipitation battery.

In FIGS. 6 and 7, the upper curve is a positive electrode potential curve, and the lower curve is a negative electrode potential curve.

In a normal battery, the number of lithium ions moving between the positive electrode and the negative electrode remains the same in the charging and discharging process. That is, in the case of a normal battery, assuming that the number of lithium ions moving from the positive electrode to the negative electrode in the charging process (the process from Q1 to Q2) is x, the number of lithium ions moving to the positive electrode is also x.

In the embodiment of FIG. 6, during charging from Q1 to Q2, the positive electrode potential increases from Q1p to Q2p, and the negative electrode potential decreases from Q1n to Q2n. Conversely, during discharging from Q2 to Q1, the positive electrode potential may decrease from Q2p to Q1p, and the negative electrode potential may increase from Q2n to Q1n. Also, at an inflection point appearing at Qx, the positive electrode potential may be Qxp and the negative electrode potential may be Qxn. Accordingly, the voltage corresponding to the inflection point of a normal battery may be Qxp-Qxn.

On the other hand, in a lithium precipitation battery, since lithium metal is precipitated on the negative electrode active material, the number of lithium ions transferred from the positive electrode to the negative electrode in the charging process may be greater than the number of lithium ions transferred from the negative electrode to the positive electrode in the discharging process. Due to this phenomenon, the positive electrode potential corresponding to the negative electrode potential is shifted to a high potential. In the embodiment of FIG. 7, at an inflection point appearing at Qx, the positive electrode potential may be Qxpp and the negative electrode potential may be Qxn. Therefore, the voltage corresponding to the inflection point of the lithium precipitation battery may be Qxpp-Qxn.

Referring to FIGS. 6 and 7, the voltage (Qxpp-Qxn) corresponding to the inflection point of the lithium precipitation battery may be greater than the voltage (Qxp-Qxn) corresponding to the inflection point of the normal battery. Therefore, the battery management apparatus 100 may diagnose whether or not lithium precipitation occurs in the battery from the battery profile BP of the charging and discharging process in consideration of the voltage behavior of the battery in which lithium is precipitated.

In addition, since the battery management apparatus 100 diagnoses lithium precipitation by considering the voltage deviation between the target voltage corresponding to the inflection point and the reference voltage serving as a criterion, there is an advantage of diagnosing whether or not lithium precipitation occurs even if the lithium metal precipitates slowly.

The control unit 120 may be configured to determine a reference temperature corresponding to the target temperature, determine a reference current amount corresponding to the target current amount, and determine a reference voltage corresponding to the reference temperature and the reference current amount in the voltage table VT.

Voltages for a plurality of temperatures and a plurality of current amounts may be included in the voltage table VT. Here, the plurality of temperatures may be temperatures selected at predetermined temperature intervals. For example, in the embodiment of FIG. 5, the plurality of temperatures may be temperatures selected at 5°C intervals.

Similarly, the plurality of current amounts may be current amounts selected at predetermined current amount intervals. For example, in the embodiment of FIG. 5, the plurality of current amounts may be current amounts selected at 5A intervals.

In one embodiment, the control unit 120 may be configured to determine a temperature closest to the target temperature among a plurality of predetermined temperatures as a reference temperature and determine a current amount closest to the target current amount among a plurality of predetermined current amounts as a reference current amount.

For example, when the same value as the target temperature and/or the target current amount is not included in the voltage table VT, the control unit 120 may determine values closest to the target temperature and/or the target current amount in the voltage table VT as a reference temperature and/or a reference current amount.

In the embodiment of FIG. 5, it is assumed that the target temperature is 24°C and the target current amount is 8A. Since the temperature equal to the target temperature is not included in the voltage table VT, the control unit 120 may determine 25°C, which is closest to the target temperature of 24°C, as a reference temperature. Also, since the current amount equal to the target current amount is not included in the voltage table VT, the control unit 120 may determine 10A closest to the target current amount 8A as a reference current amount. Accordingly, the control unit 120 may determine 5V corresponding to the reference temperature (25°C) and the reference current amount (10A) as a reference voltage.

Also, the control unit 120 may diagnose whether or not lithium precipitation occurs in the battery based on the result of comparing the reference voltage 5V with the target voltage.

In another embodiment, the control unit 120 may be configured to determine at least one reference temperature belonging to a predetermined temperature range from the target temperature among a plurality of predetermined temperatures.

For example, the predetermined temperature range may be set to be equal to the temperature interval of the plurality of temperatures included in the voltage table VT. In the embodiment of FIG. 5, the predetermined temperature range may be 5°C.

In addition, the control unit 120 may be configured to determine at least one reference current amount belonging to a predetermined current amount range from the target current amount among a plurality of predetermined current amounts.

For example, the predetermined current amount range may be set to be equal to the current amount interval of the plurality of current amounts included in the voltage table VT. In the embodiment of FIG. 5, the predetermined current amount range may be 5A.

The control unit 120 may be configured to determine a minimum voltage among at least one voltage according to the combination of the determined at least one reference temperature and the determined at least one reference current amount as a reference voltage.

For example, as in the previous embodiment, it is assumed that the target temperature is 24°C and the target current amount is 8A. The control unit 120 may determine 20°C and 24°C within a range of 5°C from the target temperature among the plurality of temperatures included in the voltage table VT as reference temperatures. In addition, the control unit 120 may determine 5A and 10A within a range of 5A from the target current amount among the plurality of current amounts included in the voltage table VT as reference current amounts. The control unit 120 may select V1, V2, V4, and V5 as candidates for the reference voltage by combining the reference temperatures (20°C and 24°C) and the reference current amounts (5A and 10A). Also, the control unit 120 may determine a minimum voltage among the selected V1, V2, V4, and V5 as a reference voltage.

In addition, the control unit 120 may diagnose whether or not lithium precipitation occurs in the battery based on the result of comparing the reference voltage with the target voltage.

In another embodiment, the control unit 120 may be configured to determine a reference voltage corresponding to the target temperature and the target current amount from the voltage table VT by using an interpolation method when a plurality of predetermined temperatures does not have the same value as the target temperature or a plurality of predetermined current amounts does not have the same value as the target current amount.

Specifically, the control unit 120 may determine two reference temperatures close to the target temperature in the voltage table VT. In addition, the control unit 120 may determine two reference current amounts close to the target current amount in the voltage table VT. In addition, the control unit 120 may determine four voltages according to the combination of two reference temperatures and two target current amounts, and determine the reference voltage by interpolating the determined four voltages to correspond to the target temperatures and the target current amounts.

For example, as in the previous embodiment, it is assumed that the target temperature is 24°C and the target current amount is 8A. The control unit 120 may determine 20°C and 25°C close to the target temperature among the plurality of temperatures included in the voltage table VT as reference temperatures. Also, the control unit 120 may determine 5A and 10A close to the target current amount among the plurality of current amounts included in the voltage table VT as reference current amounts. In addition, the control unit 120 may determine the reference voltage by interpolating the voltages V1, V2, V4, and V5 according to the combination of the reference temperatures and the reference current amounts.

As an example, the control unit 120 may interpolate voltages corresponding to the reference current amounts of 5A and 10A so as to correspond to the target current amount of 8A for each reference temperature. That is, the control unit 120 may calculate V12 by interpolating V1 and V2 at a rate corresponding to the target current amount of 8A, and calculate V45 by interpolating V4 and V5 at a rate corresponding to the target current amount of 8A. Here, the voltage corresponding to the reference temperature of 20°C and the target current amount of 8A may be V12, and the voltage corresponding to the reference temperature of 25°C and the target current amount of 8A may be V45.

Thereafter, the control unit 120 may determine a reference temperature by interpolating the interpolated voltages of V12 and V45 at a rate corresponding to the target temperature of 24°C.

Preferably, any one of various embodiments in which the control unit 120 determines the reference voltage from the voltage table VT may be applied to determine the reference voltage, or a plurality of the embodiments may be combined with each other to determine the reference voltage. In particular, when the target voltage and/or the target current amount are not included in the voltage table VT, a final reference voltage may be determined by considering at least two values among 1) a reference voltage corresponding to the nearest temperature and current amount, 2) a minimum reference voltage among a plurality of voltages according to the combination of a plurality of temperatures and current amounts, and 3) a reference voltage according to the interpolation method. For example, an average value or a median value of the plurality of values may be determined as a reference voltage.

As such, the battery management apparatus 100 according to an embodiment of the present disclosure has an advantage of determining a reference voltage in consideration of the target temperature and the target current amount in order to more accurately diagnose whether or not lithium precipitation occurs in a battery. In addition, since the reference voltage may be determined in various ways, reliability and accuracy of diagnosis results can be improved.

Referring to FIG. 1, the battery management apparatus 100 may further include a storage unit 130.

Here, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Specifically, the storage unit 130 may be communicatively connected to the inflection point extracting unit 110 and the control unit 120.

Also, the storage unit 130 may be configured to store the voltage table VT.

For example, the storage unit 130 may store the battery information regarding voltage, temperature, and current amount of the battery while the battery is being charged or discharged. Also, the storage unit 130 may store the voltage table VT.

The control unit 120 may access the storage unit 130 to first determine a target temperature and a target current amount corresponding to the target voltage. Also, the control unit 120 may determine a reference current amount corresponding to the target current amount and a reference temperature corresponding to the target temperature by referring to the voltage table VT. Finally, the control unit 120 may determine a reference voltage corresponding to the reference temperature and the reference current amount by referring to the voltage table VT.

When a reference voltage corresponding to the target temperature and the target current amount is previously stored in the voltage table VT stored in the storage unit 130 and the target voltage is less than the reference voltage, the control unit 120 may be configured to update the reference voltage to the target voltage.

That is, when the target voltage is less than the reference voltage stored in the voltage table VT, the control unit 120 may update the reference voltage to the target voltage.

As described above, since the positive electrode potential corresponding to the negative electrode potential is shifted to a high potential when lithium metal is precipitated in the battery, it is common for the target voltage to exceed the reference voltage. For example, the control unit 120 may diagnose that lithium is precipitated in the battery when the target voltage is greater than the reference voltage by the threshold voltage or more.

Conversely, when the target voltage is less than the reference voltage, since a new voltage that becomes a criterion for determining whether or not lithium precipitation occurs has appeared, the control unit 120 may update the reference voltage to the target voltage.

For example, it is assumed that the reference voltage is 3.46V and the target voltage is 3.45V. In this case, since the target voltage is less than the reference voltage, the control unit 120 may update the reference voltage to 3.45V.

After the reference voltage is updated to a smaller voltage value, it may be judged more strictly whether or not lithium precipitation occurs in the battery. Therefore, the battery management apparatus 100 has an advantage of more accurately diagnosing whether or not lithium precipitation occurs in the battery by appropriately updating the reference voltage.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the inflection point extracting unit 110, the control unit 120 and the storage unit 130 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

FIG. 8 is a diagram schematically showing an exemplary configuration of a battery pack according to another embodiment of the present disclosure.

The positive electrode terminal of the battery B may be connected to the positive electrode terminal P+ of the battery pack 10, and the negative electrode terminal of the battery B may be connected to the negative electrode terminal P- of the battery pack 10.

A measuring unit 200 may be connected to a first sensing line SL1, a second sensing line SL2, a third sensing line SL3, and a fourth sensing line SL4.

Specifically, the measuring unit 200 may be connected to a positive electrode terminal of the battery B through the first sensing line SL1, and may be connected to a negative electrode terminal of the battery B through the second sensing line SL2. The measuring unit 200 may measure the voltage of the battery B based on the voltage measured at each of the first sensing line SL1 and the second sensing line SL2.

In addition, the measuring unit 200 may be connected to an ampere meter A through the third sensing line SL3. For example, the ampere meter A may be an ammeter or a shunt resistor capable of measuring the charging current and the discharging current of the battery B. The measuring unit 200 may calculate the charging current amount by measuring the charging current of the battery B through the third sensing line SL3. Also, the measuring unit 200 may calculate the discharging current amount by measuring the discharge current of the battery B through the third sensing line SL3.

Also, the measuring unit 200 is connected to the battery B through the fourth sensing line SL4, and may measure the temperature of the battery B in the charging process of the battery B.

The charging and discharging device 20 may be connected to the battery pack 10 and configured to charge and/or discharge the battery B.

Specifically, one end of the charging and discharging device 20 may be connected to the positive electrode terminal P+ of the battery pack 10, and the other end may be connected to the negative electrode terminal P- of the battery pack 10. Therefore, the positive electrode terminal of the battery B, the positive electrode terminal P+ of the battery pack 10, the charging and discharging device 20, the negative electrode terminal P- of the battery pack 10, and the negative electrode terminal of the battery B may be electrically connected.

Meanwhile, the battery management apparatus 100 according to the present disclosure may be provided in a server.

Specifically, the server may be directly and/or indirectly connected to a BMS connected to a battery through a wired/wireless network. For example, the server may be a cloud server.

The server may be directly connected to the BMS or indirectly connected to the BMS through other devices connected to the BMS. For example, a user terminal connected to the BMS may be connected to the server, or a charging device (e.g., a charger or a charging station) connected to the BMS may be connected to the server.

The server may receive the battery information (temperature, current amount, and voltage) and the battery profile BP from the BMS. Also, based on the received battery information and battery profile BP, the server may diagnose whether or not lithium precipitation occurs in the battery.

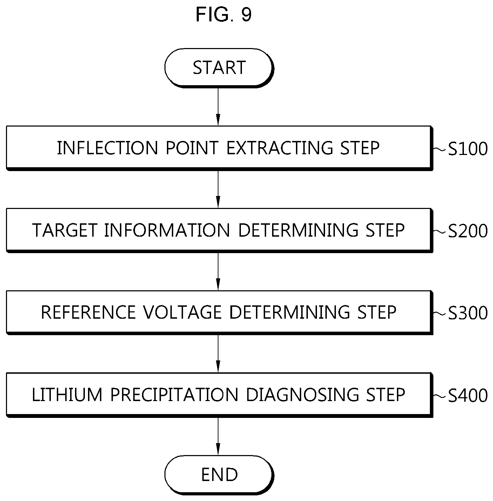

FIG. 9 is a diagram schematically showing a battery management method according to still another embodiment of the present disclosure.

Preferably, each step of the battery management method may be performed by the battery management apparatus 100. Hereinafter, for convenience of explanation, contents overlapping with the previously described contents will be omitted or briefly described.

Referring to FIG. 9, the battery management method may include an inflection point extracting step (S100), a target information determining step (S200), a reference voltage determining step (S300), and a lithium precipitation diagnosing step (S400).

The inflection point extracting step (S100) is a step of extracting an inflection point in a battery profile BP representing a voltage change of a battery over time, and may be performed by the inflection point extracting unit 110.

For example, in the embodiment of FIG. 2, the inflection point extracting unit 110 may extract an inflection point in a CC section of the battery profile BP.

The target information determining step (S200) is a step of determining a target voltage, a target temperature, and a target current amount of the battery corresponding to the inflection point, and may be performed by the control unit 120.

For example, in the charging and discharging process of the battery, not only the voltage of the battery but also the temperature and the charging and discharging current amount may be measured together. Accordingly, the control unit 120 may determine a target temperature and a target current amount corresponding to the target voltage.

The reference voltage determining step (S300) is a step of determining a reference voltage corresponding to the target temperature and the target current amount in a preset voltage table VT, and may be performed by the control unit 120.

For example, the control unit 120 may first determine a reference temperature corresponding to the target temperature and a reference current amount corresponding to the target current amount in the voltage table VT. Also, the control unit 120 may determine a reference voltage corresponding to the reference temperature and the reference current amount in the voltage table VT.

The lithium precipitation diagnosing step (S400) is a step for diagnosing whether or not lithium precipitation occurs in the battery based on the reference voltage and the target voltage, and may be performed by the control unit 120.

For example, the control unit 120 may calculate a voltage deviation between the reference voltage and the target voltage. Also, if the voltage deviation is equal to or greater than a preset threshold voltage, the control unit 120 may be configured to diagnose that lithium is precipitated in the battery. Conversely, if the voltage deviation is less than the threshold voltage, the control unit 120 may be configured to diagnose that lithium is not precipitated in the battery. For example, the threshold voltage may be set to 10mV.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present invention has been described in detail. However, it should be understood that the detailed description and specific examples, while indicating preferred embodiments of the invention, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the scope of the invention, which is defined in the appended claims.

### (Reference Signs)

- 10:: battery pack
- 20:: charging and discharging device
- 100:: battery management apparatus
- 110:: inflection point extracting unit
- 120:: control unit
- 130:: storage unit
- 200:: measuring unit

## Claims

1. A battery management apparatus (100), comprising:
an inflection point extracting unit (110) configured to extract an inflection point from a battery profile representing a voltage change of a battery (B) over time using a constant charging or discharging current; and
a control unit (120) configured to determine a target voltage, a target temperature, and a target current amount of the battery (B) corresponding to the inflection point, determine a reference voltage corresponding to the target temperature and the target current amount in a preset voltage table, and diagnose whether or not lithium precipitation occurs in the battery (B) based on the reference voltage and the target voltage.

2. The battery management apparatus (100) according to claim 1,
wherein the control unit (120) is configured to diagnose whether or not lithium precipitation occurs based on a voltage deviation between the reference voltage and the target voltage.

3. The battery management apparatus (100) according to claim 2,
wherein the control unit (120) is configured to diagnose that the lithium precipitation occurs in the battery (B), when the voltage deviation is equal to or greater than a preset threshold voltage, and
wherein the control unit (120) is configured to diagnose that the lithium precipitation does not occur in the battery (B) when the voltage deviation is less than the threshold voltage.

4. The battery management apparatus (100) according to claim 1,
wherein the control unit (12) is configured to determine a reference temperature corresponding to the target temperature, determine a reference current amount corresponding to the target current amount, and determine the reference voltage corresponding to the reference temperature and the reference current amount in the voltage table.

5. The battery management apparatus (100) according to claim 4,
wherein the control unit (120) is configured to determine a temperature closest to the target temperature among a plurality of predetermined temperatures as the reference temperature, and determine a current closest to the target current amount among a plurality of predetermined current amounts as the reference current amount.

6. The battery management apparatus (100) according to claim 4,
wherein the control unit (120) is configured to determine at least one reference temperature belonging to a predetermined temperature range from the target temperature among a plurality of predetermined temperatures, determine at least one reference current amount belonging to a predetermined current amount range from the target current amount among a plurality of predetermined current amounts, and determine a minimum voltage among the at least one voltage according to the combination of the determined at least one reference temperature and the determined at least one reference current amount as the reference voltage.

7. The battery management apparatus (100) according to claim 4,
wherein the control unit (120) is configured to determine the reference voltage corresponding to the target temperature and the target current amount in the voltage table by using an interpolation method, when a plurality of predetermined temperatures do not have the same value as the target temperature or a plurality of predetermined current amounts do not have the same value as the target current amount.

8. The battery management apparatus (100) according to claim 1,
wherein the voltage table is a table in which a voltage of the battery (B) according to a temperature of the battery (B) and a current amount of the battery (B) is recorded.

9. The battery management apparatus (100) according to claim 1,
wherein the battery profile is a profile recorded to represent the voltage according to a charging time or a discharging time when the battery (B) is charged or discharged with a constant current.

10. The battery management apparatus (100) according to claim 1, further comprising:
a storage unit (130) configured to store the voltage table,
wherein the control unit (120) is configured to store the reference voltage corresponding to the target temperature and the target current amount in advance in the voltage table stored in the storage unit (130) and update the reference voltage to the target voltage when the target voltage is less than the reference voltage.

11. A battery pack (10), comprising the battery management apparatus (100) according to any one of claims 1 to 10.

12. A battery management server, comprising the battery management apparatus (100) according to any one of claims 1 to 10.

13. A battery management method, comprising:
an inflection point extracting step (S100) of extracting an inflection point from a battery profile representing a voltage change of a battery over time using a constant charging or discharging current;
a target information determining step (S200) of determining a target voltage, a target temperature, and a target current amount of the battery corresponding to the inflection point;
a reference voltage determining step (S300) of determining a reference voltage corresponding to the target temperature and the target current amount in a preset voltage table; and
a lithium precipitation diagnosing step (S400) of diagnosing whether or not lithium precipitation occurs in the battery based on the reference voltage and the target voltage.

## Patentansprüche

1. Batterieverwaltungsvorrichtung (100), umfassend:
eine Wendepunkt-Extrahiereinheit (110), welche dazu eingerichtet ist, unter Verwendung eines konstanten Lade- oder Entladestroms einen Wendepunkt aus einem Batterieprofil zu extrahieren, welches eine Spannungsänderung einer Batterie (B) über eine Zeit repräsentiert; und
eine Steuereinheit (120), welche dazu eingerichtet ist, eine Zielspannung, eine Zieltemperatur und eine Zielstrommenge der Batterie zu bestimmen, welche dem Wendepunkt entsprechen, in einer vorfestgelegten Spannungstabelle eine Referenzspannung zu bestimmen, welche der Zieltemperatur und der Zielstrommenge entspricht, und auf Grundlage der Referenzspannung und der Zielspannung zu diagnostizieren, ob eine Lithiumabscheidung in der Batterie (B) auftritt oder nicht.

2. Batterieverwaltungsvorrichtung (100) nach Anspruch 1,
wobei die Steuereinheit (120) dazu eingerichtet ist, auf Grundlage einer Spannungsabweichung zwischen der Referenzspannung und der Zielspannung zu diagnostizieren, ob eine Lithiumabscheidung auftritt oder nicht.

3. Batterieverwaltungsvorrichtung (100) nach Anspruch 2,
wobei die Steuereinheit (120) dazu eingerichtet ist, zu diagnostizieren, dass die Lithiumabscheidung in der Batterie (B) auftritt, wenn die Spannungsabweichung gleich wie oder größer als eine vorfestgelegte Schwellenwertspannung ist, und
wobei die Steuereinheit (120) dazu eingerichtet ist, zu diagnostizieren, dass die Lithiumabscheidung in der Batterie (B) nicht auftritt, wenn die Spannungsabweichung kleiner als die vorfestgelegte Schwellenwertspannung ist.

4. Batterieverwaltungsvorrichtung (100) nach Anspruch 1,
wobei die Steuereinheit (12) dazu eingerichtet ist, eine Referenztemperatur zu bestimmen, welche der Zieltemperatur entspricht, eine Referenzstrommenge zu bestimmen, welche der Zielstrommenge entspricht, und die Referenzspannung zu bestimmen, welche in der Spannungstabelle der Referenztemperatur und der Referenzstrommenge entspricht.

5. Batterieverwaltungsvorrichtung (100) nach Anspruch 4,
wobei die Steuereinheit (120) dazu eingerichtet ist, eine Temperatur, welche aus einer Mehrzahl vorbestimmter Temperaturen am nächsten zu der Zieltemperatur ist, als die Referenztemperatur zu bestimmen und einen Strom, welcher aus einer Mehrzahl vorbestimmter Strommengen am nächsten zu der Zielstrommenge ist, als die Referenzstrommenge zu bestimmen.

6. Batterieverwaltungsvorrichtung (100) nach Anspruch 4,
wobei die Steuereinheit (120) dazu eingerichtet ist, wenigstens eine Referenztemperatur, welche zu einem vorbestimmten Temperaturbereich von der Zieltemperatur gehört, aus einer Mehrzahl vorbestimmter Temperaturen zu bestimmen, wenigstens eine Referenzstrommenge, welche zu einem vorbestimmten Strommengenbereich von der Zielstrommenge gehört, aus einer Mehrzahl vorbestimmter Strommengen zu bestimmen, und gemäß der Kombination der bestimmten wenigstens einen Referenztemperatur und der bestimmten wenigstens einen Referenzstrommenge eine minimale Spannung aus der wenigstens einen Spannung als die Referenzspannung zu bestimmen.

7. Batterieverwaltungsvorrichtung (100) nach Anspruch 4,
wobei die Steuereinheit (120) dazu eingerichtet ist, die Referenzspannung, welche in der Spannungstabelle der Zieltemperatur und der Zielstrommenge entspricht, unter Verwendung eines Interpolationsverfahrens zu bestimmen, wenn eine Mehrzahl vorbestimmter Temperaturen nicht den gleichen Wert wie die Zieltemperatur aufweist oder wenn eine Mehrzahl vorbestimmter Strommengen nicht den gleichen Wert wie die Zielstrommenge aufweist.

8. Batterieverwaltungsvorrichtung (100) nach Anspruch 1,
wobei die Spannungstabelle eine Tabelle ist, in welcher eine Spannung der Batterie (B) gemäß einer Temperatur der Batterie (B) und einer Strommenge der Batterie (B) erfasst ist.

9. Batterieverwaltungsvorrichtung (100) nach Anspruch 1,
wobei das Batterieprofil ein Profil ist, welches erfasst ist, um die Spannung gemäß einer Ladezeit oder einer Entladezeit zu repräsentieren, wenn die Batterie (B) mit einem konstanten Strom geladen oder entladen wird.

10. Batterieverwaltungsvorrichtung (100) nach Anspruch 1, ferner umfassend:
eine Speichereinheit (130), welche dazu eingerichtet ist, die Spannungstabelle zu speichern,
wobei die Steuereinheit (120) dazu eingerichtet ist, die Referenzspannung, welche der Zieltemperatur und der Zielstrommenge entspricht, im Voraus in der Spannungstabelle zu speichern, welche in der Speichereinheit (130) gespeichert ist, und die Referenzspannung auf die Zielspannung zu aktualisieren, wenn die Zielspannung kleiner als die Referenzspannung ist.

11. Batteriepack (10), umfassend die Batterieverwaltungsvorrichtung (100) nach einem der Ansprüche 1 bis 10.

12. Batterieverwaltungsserver, umfassend die Batterieverwaltungsvorrichtung (100) nach einem der Ansprüche 1 bis 10.

13. Batterieverwaltungsverfahren, umfassend:
einen Wendepunkt-Extrahierschritt (S100) eines Extrahierens eines Wendepunktes aus einem Batterieprofil, welches eine Spannungsänderung einer Batterie über eine Zeit repräsentiert, unter Verwendung eines konstanten Lade- oder Entladestroms;
einen Zielinformation-Bestimmungsschritt (S200) eines Bestimmens einer Zielspannung, einer Zieltemperatur und einer Zielstrommenge der Batterie, welche dem Wendepunkt entsprechen;
einen Referenzspannung-Bestimmungsschritt (S300) eines Bestimmens einer Referenzspannung, welche in einer vorfestgelegten Spannungstabelle der Zieltemperatur und der Zielstrommenge entspricht; und
einen Lithiumabscheidung-Diagnostizierschritt (S400) eines Diagnostizierens, ob in der Batterie eine Lithiumabscheidung auftritt oder nicht, auf Grundlage der Referenzspannung und der Zielspannung.

## Revendications

1. Appareil de gestion de batterie (100), comprenant :
une unité d'extraction de point d'inflexion (110) configurée pour extraire un point d'inflexion d'un profil de batterie représentant un changement de tension d'une batterie (B) au fil du temps à l'aide d'un un courant de charge ou de décharge constant ; et
une unité de commande (120) configurée pour déterminer une tension cible, une température cible et une quantité de courant cible de la batterie (B) correspondant au point d'inflexion, déterminer une tension de référence correspondant à la température cible et à la quantité de courant cible dans un tableau de tensions prédéfini, et diagnostiquer si une précipitation de lithium se produit ou non dans la batterie (B) sur la base de la tension de référence et de la tension cible.

2. Appareil de gestion de batterie (100) selon la revendication 1,
dans lequel l'unité de commande (120) est configurée pour diagnostiquer si une précipitation de lithium se produit ou non sur la base d'un écart de tension entre la tension de référence et la tension cible.

3. Appareil de gestion de batterie (100) selon la revendication 2,
dans lequel l'unité de commande (120) est configurée pour diagnostiquer que la précipitation de lithium se produit dans la batterie (B), lorsque l'écart de tension est supérieur ou égal à une tension seuil prédéfinie, et
dans lequel l'unité de commande (120) est configurée pour diagnostiquer que la précipitation de lithium ne se produit pas dans la batterie (B) lorsque l'écart de tension est inférieur à la tension seuil.

4. Appareil de gestion de batterie (100) selon la revendication 1,
dans lequel l'unité de commande (12) est configurée pour déterminer une température de référence correspondant à la température cible, déterminer une quantité de courant de référence correspondant à la quantité de courant cible, et déterminer la tension de référence correspondant à la température de référence et à la quantité de courant de référence dans le tableau de tension.

5. Appareil de gestion de batterie (100) selon la revendication 4,
dans lequel l'unité de commande (120) est configurée pour déterminer une température la plus proche de la température cible parmi une pluralité de températures prédéterminées comme température de référence, et déterminer un courant le plus proche de la quantité de courant cible parmi une pluralité de quantités de courant prédéterminées comme quantité de courant de référence.

6. Appareil de gestion de batterie (100) selon la revendication 4,
dans lequel l'unité de commande (120) est configurée pour déterminer au moins une température de référence appartenant à une plage de températures prédéterminées à partir de la température cible parmi une pluralité de températures prédéterminées, déterminer au moins une quantité de courant de référence appartenant à une plage de quantités de courant prédéterminées à partir de la quantité de courant cible parmi une pluralité de quantités de courant prédéterminées, et déterminer une tension minimale parmi l'au moins une tension selon la combinaison de l'au moins une température de référence déterminée et de l'au moins une quantité de courant de référence déterminée comme tension de référence.

7. Appareil de gestion de batterie (100) selon la revendication 4,
dans lequel l'unité de commande (120) est configurée pour déterminer la tension de référence correspondant à la température cible et la quantité de courant cible dans le tableau de tensions à l'aide d'un procédé d'interpolation, lorsqu'une pluralité de températures prédéterminées n'ont pas la même valeur que la température cible ou une pluralité de quantités de courant prédéterminées n'ont pas la même valeur que la quantité de courant cible.

8. Appareil de gestion de batterie (100) selon la revendication 1,
dans lequel le tableau de tension est un tableau dans lequel une tension de la batterie (B) en fonction d'une température de la batterie (B) et d'une quantité de courant de la batterie (B) est enregistrée.

9. Appareil de gestion de batterie (100) selon la revendication 1,
dans lequel le profil de batterie est un profil enregistré pour représenter la tension en fonction d'un temps de charge ou d'un temps de décharge lorsque la batterie (B) est chargée ou déchargée avec un courant constant.

10. Appareil de gestion de batterie (100) selon la revendication 1, comprenant en outre :
une unité de stockage (130) configurée pour stocker la table de tension,
dans lequel l'unité de commande (120) est configurée pour stocker la tension de référence correspondant à la température cible et à la quantité de courant cible à l'avance dans le tableau de tension stocké dans l'unité de stockage (130) et mettre à jour la tension de référence à la tension cible lorsque la tension cible est inférieure à la tension de référence.

11. Bloc-batterie (10), comprenant l'appareil de gestion de batterie (100) selon l'une quelconque des revendications 1 à 10.

12. Serveur de gestion de batterie, comprenant l'appareil de gestion de batterie (100) selon l'une quelconque des revendications 1 à 10.

13. Procédé de gestion de batterie, comprenant :
une étape d'extraction de point d'inflexion (S100) pour extraire un point d'inflexion à partir d'un profil de batterie représentant une variation de tension d'une batterie au fil du temps à l'aide d'un courant de charge ou de décharge constant ;
une étape de détermination d'informations cible (S200) pour déterminer une tension cible, une température cible et une quantité de courant cible de la batterie correspondant au point d'inflexion ;
une étape de détermination de tension de référence (S300) pour déterminer une tension de référence correspondant à la température cible et à la quantité de courant cible dans un tableau de tensions prédéfini ; et
une étape de diagnostic de précipitation de lithium (S400) pour diagnostiquer si une précipitation de lithium se produit dans la batterie sur la base de la tension de référence et de la tension cible.
